# EUROPEAN PATENT APPLICATION

(11) **EP 2 071 188 A1**
(43) Date of publication of application: **17.06.2009**
(21) Application number: 07425781.7
(22) Date of filing: 10.12.2007
(51) Int. Cl.: F04B 37/02, H01J 7/18, H01J 41/12, C23C 14/16, H01J 37/34

(54) **Device for the deposition of non-evaporable getters (NEGs) and method of deposition using said device**

(71) Applicant: VARIAN S.p.A., 10040 Leini' (Torino) (IT)
(72) Inventor: Paolini, Chiara, 10040 Leini' (TO) (IT); Ravelli, Fabio, 10040 Leini' (TO) (IT)
(74) Representative: Robba, Pierpaolo

(57) **Abstract**

A device (1) for the deposition of a non-evaporable getter (NEG), comprising: a supporting plate (3); one or more first electrodes (5) capable of diffusing NEG material by cathode sputtering; and one or more second electrodes (7) capable of diffusing catalyst by cathode sputtering; wherein said first and second electrodes are associated with said supporting plate (3). The invention also concerns a method using said device.

## Description

The present invention relates to a device for the deposition of non-evaporable getters (NEGs) and to a corresponding method of deposition using said device.

More particularly, the present invention relates to a device and a method for the deposition of NEG material that, thanks to its properties of capturing gas molecules, is capable of generating UHV (Ultra High Vacuum) conditions in a vacuum chamber defined by a metal wall that can release gas at its surface.

In such a vacuum chamber, where ultra high vacuum conditions (i.e. pressure conditions below 10⁻⁷ Pa and preferably below 10⁻¹⁰ Pa) are to be created, the metal walls are a constant gas source. Consequently, the vacuum level attainable inside the vacuum chamber is defined by the dynamic equilibrium between the pumping rate of the pump system being used and the rate at which gas is released from the surfaces of the metal walls.

In order to improve the vacuum level attainable, it has been proposed to deposit a layer of getter, and more particularly of non-evaporable getter (NEG), on the metal walls of the chamber.

Getters are materials capable of reacting with gases present in the vacuum chamber (in particular, H₂, O₂, N₂, CO₂, CO) and of providing stable compounds, thereby causing the disappearance of said gases, which corresponds to a pumping effect. Examples of getters are titanium, zirconium, vanadium, scandium and alloys thereof.

In order the desired chemical reaction can properly take place, it is necessary that the getter surface is clean and not oxidised, i.e. free from passivated surface layers.

According to the prior art, such passivated surface layers can be eliminated by making the surface gases, mainly O₂, diffuse towards the interior of the getter by heating (activation phase).

A method of depositing an NEG layer in a vacuum chamber in order to create ultra high vacuum conditions is disclosed for instance in WO 97/49109.

In order to dispense with the phase of NEG film activation, carried out in order to diffuse mainly O₂, it has been proposed to deposit on the metal walls of the chamber a multilayer coating consisting of an NEG undercoat on which a thin coating of a catalyst, chosen out of the group ruthenium, rhodium, palladium, osmium, iridium, platinum and/or alloys thereof.

The above catalysts have a low oxidability and, if exposed to air, only marginally react with oxygen. Thus, thanks to the use of a coating of catalyst, it is possible to prevent the formation of passivated surface layers on the NEG surface and, consequently, it is possible to dispense with the phase of activation by heating.

The catalyst layer, while inhibiting pumping of O₂, N₂ and CO₂, allows maintaining pumping of H₂, this being the gas diffusion of which inside the chamber has especially to be prevented.

A method of deposition of a multilayer coating comprising an NEG undercoat and an outer catalyst coating is disclosed in WO 98/37958.

The method disclosed in WO 98/37958 comprises depositing an NEG undercoat on the walls of the vacuum chamber by using a first electrode capable of NEG deposition by exploiting the phenomenon known as cathode sputtering, and subsequently removing such a first electrode from the vacuum chamber and introducing a second electrode for depositing a layer of catalyst, e.g. palladium, still by cathode sputtering, thereby forming a thin coating on the NEG undercoat.

The term "sputter deposition" denotes a method of deposition of thin films through the erosion, due to the combined action of an electric and a magnetic field, of an electrode formed by a source material. The vapour phase sputtered atoms emitted by the source tend to become deposited on the surrounding surfaces, covering them and forming thin coating films that will have the same composition as the material forming the electrode.

A clear drawback of the method described above is that the replacement of the first electrode by the second electrode, performed in the presence of air at ambient conditions, results in oxidation and consequent passivation of the NEG undercoat deposited in the preceding phase. Consequently, in order the catalyst can be deposited on a "clean" surface, an intermediate phase of NEG activation is to be provided in order to eliminate the passivated surface layer.

That intermediate phase makes the process complex and expensive and, above all, considerably increases the process duration.

To obviate that drawback, it has been proposed to perform the replacement of the first electrode by the second electrode under vacuum conditions. Yet, such a solution would be very expensive and difficult to be implemented, taking also into account the size of the electrodes, which can be of some millimetres in diameter and more than one metre in length.

It is the main object of the present invention to remedy the drawbacks of the prior art, by providing a device for the deposition of a layer of non-evaporable getter (NEG), which device also is capable of performing the deposition of a catalyst layer without need of exposing the chamber to air.

It is another object of the present invention to provide a device capable of performing the deposition of a layer of non-evaporable getter (NEG) and of a catalyst layer in a quicker and cheaper way than the prior art.

It is a further object of the present invention to provide a device capable of performing the deposition of a layer of non-evaporable getter (NEG) and of a catalyst layer, which layers ensure an effective pumping effect in respect of H₂.

The above and other objects are achieved by the device and the method according to the invention, as claimed in the appended claims.

Thanks to the provision of one or more electrodes for NEG deposition and one or more electrodes for catalyst deposition, which electrodes are mounted on the same supporting plate, the device according to the invention enables depositing a multilayer NEG - catalyst coating in a single sequence, without need of replacing the electrodes and without moving same.

Advantageously, said one or more electrodes for NEG deposition and said one or more electrodes for catalyst deposition are located on the supporting plate according to such a geometrical configuration that deposition of a layer of material that is substantially homogeneous and uniform over the whole wall of the surrounding chamber is ensured.

More particularly, according to a preferred embodiment of the present invention, there are provided a single electrode for NEG deposition, centrally located on the supporting plate, and multiple electrodes for catalyst deposition, uniformly distributed along a circumference centred on said electrode for NEG deposition.

Further features and advantages of the device according to the present invention will become more apparent from the following detailed description of a preferred embodiment of the invention, given by way of non limiting example with reference to the accompanying drawings, in which:
- Fig. 1 is a side view of the device according to the invention;
- Fig. 2 is a cross-sectional view taken along line II - II of Fig. 1;
- Fig. 3 is a cross-sectional view taken along line III - III of Fig. 2;
- Fig. 4 is a block diagram of the steps of the method of deposition according to the invention;
- Fig. 5 schematically shows the device according to the invention when it is located inside a vacuum chamber;
- Fig. 6 is an enlarged cross-sectional view of the NEG coating;
- Fig. 7 is an enlarged cross-sectional view of the complete NEG - catalyst coating.

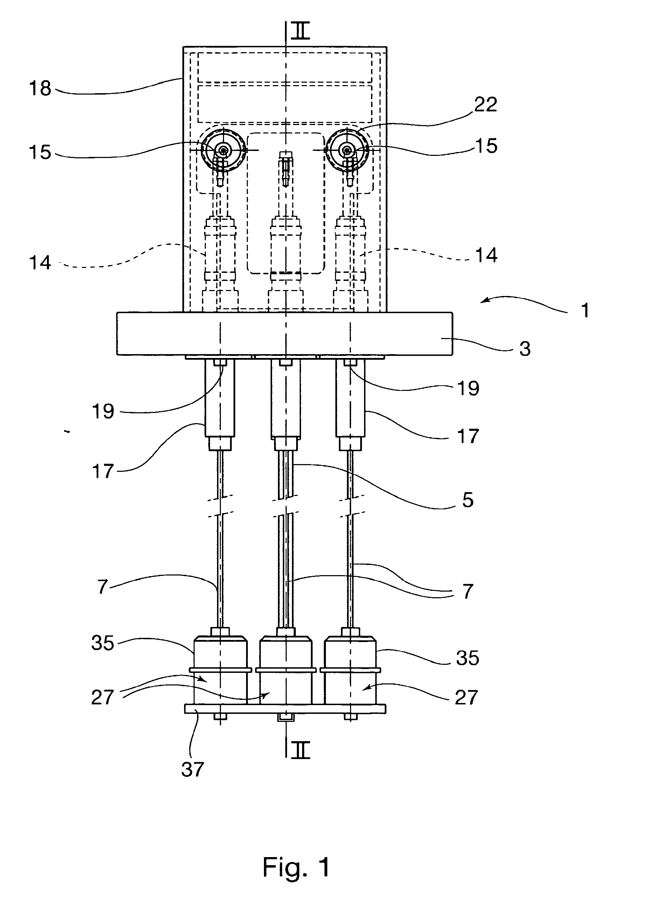

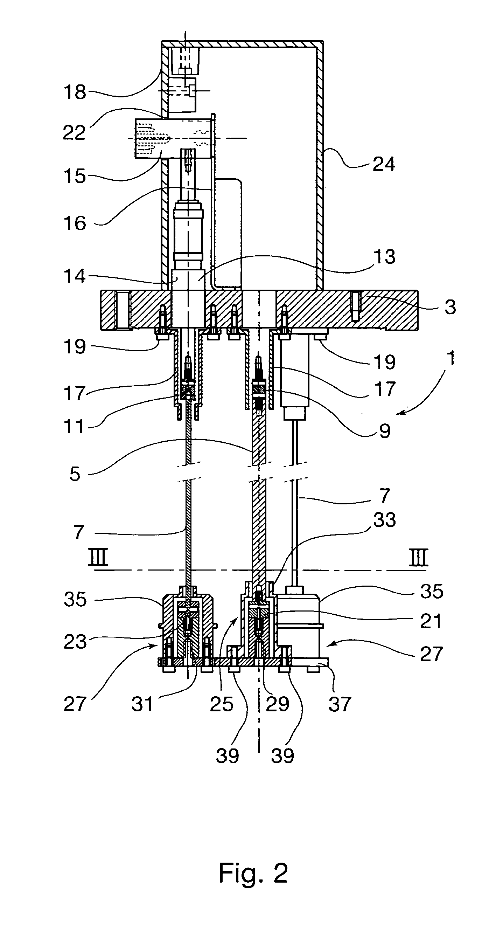

Referring to Figs. 1 and 2, there is shown a device 1 according to the invention for the deposition of a multilayer coating resulting from the superposition of a catalyst layer on an NEG undercoat.

According to the invention, said device 1 includes a first supporting plate 3, for instance a circular plate as in the illustrated example, which has secured thereto both one or more first electrodes 5 for NEG (Non-Evaporable Getter) deposition, and one or more second electrodes 7 for catalyst deposition.

In the illustrated example, supporting plate 3 bears a single first electrode 5 made of NEG for the deposition of a corresponding NEG layer by cathode sputtering, and three second electrodes 7 for the deposition of a corresponding catalyst layer, still by cathode sputtering.

Preferably, the first electrode 5 is made of a titanium-zirconium-vanadium alloy, and more preferably of an alloy containing 26% titanium, 38% zirconium and 36% vanadium (percentages in weight). However, other getters, such as for instance hafnium, scandium and alloys thereof, could be used. In the illustrated embodiment, said first electrode 5 consists of a rod with a diameter of about 6 mm and a length of about 1.25 m.

Preferably, said second electrodes 7 are made of palladium. However, other catalysts, such as for instance ruthenium, rhodium, osmium, iridium, platinum and alloys thereof, could be used. In the illustrated embodiment, said second electrodes 7 consist of wires of palladium with a diameter of about 2 mm and a length of about 1.25 m.

Still referring to Figs. 1 and 2, electrodes 5 and 7 are secured to the first supporting plate 3 at their top ends, by means of suitable adapters 9 and 11, respectively.

Adapters 9 and 11 are made of a conductive material and are associated with respective high voltage feedthroughs 13 and 14 in turn connected to high voltage electric connectors 15 supported by a bracket 16. Said connectors 15 enable connecting the electrodes to a power supply for energising electrodes 5, 7 (typically, at a voltage of 500 to 1000 V) during the cathode sputtering process. More particularly, thanks to connectors 15, the first electrode 5 or the second electrodes 7 can be alternately energised, depending on the coating layer to be deposited.

A respective screen 17, preferably cylindrical, secured to supporting plate 3 by means of screws 19, is provided around adapter 9, 11 of each electrode 5, 7.

A protecting envelope 18, having a cover 24 and holes 22 for connectors 15, surrounds bracket 16 and the region of plate 3 where high voltage feedthroughs 13, 14 are provided.

At their bottom ends, electrodes 5, 7 are secured, through connectors 25, 27 and screws 39, to a second supporting plate 37 acting also for centring electrodes 5, 7. Connectors 25, 27 include adapters 21, 23 and internally house ceramic insulators 29, 31, while being externally equipped with screens 33, 35.

The second plate 37 and the other elements associated therewith, such as connectors 25, 27 and screws 39, also act as a counterweight and therefore they assist in keeping electrodes 5, 7 straight when device 1 is vertically suspended through plate 3, as shown in Figs. 1 and 2. Such a vertical arrangement of device 1 corresponds to the position generally taken by the device when operating inside a vacuum chamber to be coated, as it will become apparent from the following description.

According to the invention, during operation of device 1, and more precisely during the whole process of deposition of the NEG undercoat and the catalyst layer, the first electrode 5 and the second electrodes 7 will be simultaneously present inside the chamber to be coated.

More particularly, the second electrodes 7 will be present during the step of deposition of the NEG undercoat by the first electrode 5 and, conversely, the first electrode 5 will be present during the step of deposition of the catalyst coating layer by the second electrodes 7, as it will be described in more detail below.

What stated above shows that the arrangement of the first and second electrodes 5, 7 must take into account two aspects:
- the shadow effect exerted by each electrode during operation of the other electrodes;
- the contamination of each electrode by the material deposited by the electrodes.

The shadow effect entails that the layer deposited on the chamber wall may not be homogeneous and uniform due to the interference ("shadow") of the other electrodes that are interposed between the electrodes currently energised and the chamber wall. Said shadow effect can be particularly penalising during catalyst deposition since, as mentioned above, the first electrode 5 generally has a far greater diameter (typically, about three times greater) than the second electrodes 7.

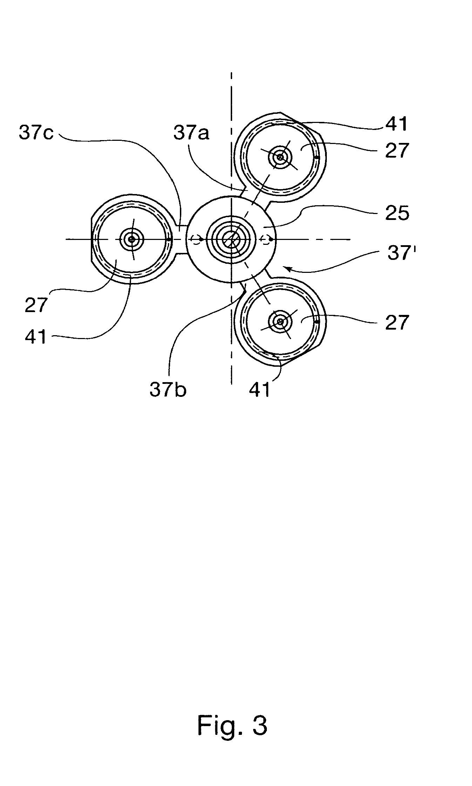

Turning now to Fig. 3, where a preferred embodiment of the invention is shown, in order to minimise the shadow effect, the first electrode 5 for the deposition of the NEG layer is centrally located, whereas the second electrodes 7 are equally spaced along a circumference centred on said first electrode 5. Since three second electrodes 7 are provided in the illustrated example, said second electrodes 7 will be mutually spaced apart by 120°, as shown in Fig. 3.

In corresponding manner, the second supporting plate 37 comprises a central portion 37' to which connector 25 of the first electrode 5 is secured, and three arms 37a, 37b, 37c, mutually spaced apart by120° and having respective peripheral portions 41 to which a respective connector 27 is secured.

Such an arrangement allows reducing the mutual shadow effect of the electrodes, and in particular of the first electrode 5 on the second electrodes 7, thereby allowing a homogeneous and uniform deposition to be achieved.

In order to reduce the effect of contamination of electrodes 5, 7 due to the deposition of NEG or catalyst coming from the other electrodes, it is advisable that the mutual spacing of the first electrode 5 and the second electrodes 7 is as great as possible. On the other hand, the distance of electrodes 7 from the walls of the vacuum chamber to be coated, which generally is cylindrical, cannot be excessively reduced, since it must be sufficient to allow a homogeneous coating and it is determined by the intensity of the magnetic field allowing sputter deposition. As an indication, the distance of electrodes 7 from the walls of the chamber could be in the range 10 to 20 mm when the magnetic field generated by the solenoid surrounding the chamber to be coated produces a magnetic field of about 150 Gauss.

Assuming that the radius of the vacuum chamber is of the same order as that of the first plate 3, the second electrodes 7 will therefore be arranged along a circumference centred on central electrode 5 and having a radius exceeding 50% of the radius of the first supporting plate 3 and preferably ranging from 70% to 80% of said radius.

By way of example, on a plate 3 with radius 75 mm, the first electrode 5 will be located at the centre of plate 3 and the second electrodes 7 will be arranged along a circumference having a radius of about 55 mm, centred on said first electrode 5.

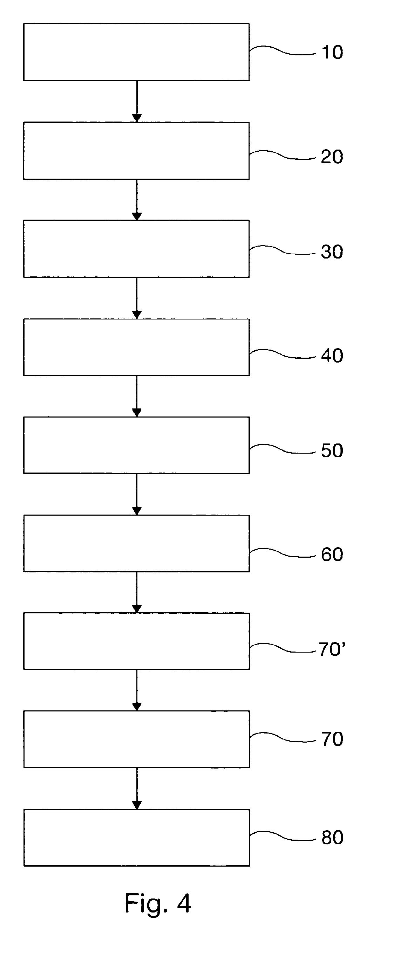

Turning to the block diagram shown in Fig. 4, the operation of device 1 according to the invention comprises the steps of:
- arranging a device 1 inside the chamber to be coated (step 10);
- evacuating the chamber to be coated, by bringing the inside space preferably to a pressure of the order of 10⁻⁷ Pa (step 20);
- introducing a noble gas, e.g. Kr, into the chamber, and bringing the chamber to a pressure in the range of about 1 to 5 Pa (step 30);
- energising the solenoid and the first electrode 5, for a predetermined time, to obtain the deposition of a corresponding NEG undercoat with the desired thickness onto the chamber wall (step 40);
- stopping energising the first electrode 5 (step 50);
- without discontinuity in the vacuum conditions of the chamber, energising the second electrodes 7 made of catalyst (step 60);
- obtaining the deposition of a corresponding catalyst layer with the desired thickness onto the chamber wall, on the previously deposited NEG layer (step 70);
- stopping energising the second electrodes 7, turning off the solenoid and removing the device from the chamber (step 80).

As mentioned above, both the deposition of the NEG layer and the deposition of the catalyst layer are carried out by cathode sputtering, in known manner, and therefore such processes are not described in detail herein.

It is however to be appreciated that, contrary to the teaching of the prior art, according to which only one kind of electrode at a time, i.e. NEG or catalyst, is present inside the vacuum chamber, according to the invention the second electrodes 7 are present inside the vacuum chamber during the step of NEG deposition, and therefore they will be at least partly coated with an NEG layer at the end of the first deposition step.

Consequently, when the second electrodes 7 will be energised, the deposition of the material they are made of, i.e. catalyst, will be preceded by an initial step of cleaning of said electrodes (step 70'), during which the NEG layer will be removed from the same electrodes, which will subsequently perform the deposition of the catalyst layer.

Therefore, in an initial period, even if only the second electrodes 7 are energised, NEG deposition will still take place.

Similarly, at the end of the catalyst deposition step, the first electrode 5 will be coated with a thin catalyst layer that will be removed the next time the device according to the invention is used and that will become deposited on the chamber walls. However, the thickness of such an initial catalyst layer is so limited that it does not affect the operation of the NEG layer that will be deposited thereon.

Typically, in the method according to the invention, an NEG undercoat about 1 µm thick and subsequently a catalyst layer about 100 nm thick are deposited. As mentioned above, a titanium-zirconium-vanadium alloy is preferably used as NEG material, and palladium is preferably used as catalyst.

When coating ion pumps, it has been realised that deposition of an NEG layer 1 µm thick demands about 9 hours, and deposition of a catalyst layer about 100 nm thick demands about 1.5 hours. Moreover, deposition of an NEG layer 1 µm thick on the chamber walls results in the deposition of a layer about 2 µm thick on the second electrodes 7, cleaning of which demands about 1 hour, whereby the overall process time is about 12 to 12.5 hours. The time needed for cleaning the first electrode from the contamination with catalyst at the end of the process can on the contrary be neglected, since it is less than 5 min.

An overall process time of about 12 hours is about 20 hours shorter than the process time of the prior art methods, demanding replacement of the electrodes inside the chamber to be coated and the activation of the previously deposited NEG film, before depositing the catalyst layer.

Therefore, the above description shows that the device and the method according to the invention allow attaining the desired objects, since they allow forming a two-layer coating comprising an NEG undercoat and a catalyst coating layer without replacing or moving the electrodes and without need of bringing the system back to atmospheric pressure between the two different deposition steps. This results in a reduction of process costs and time, while resulting anyway in homogeneous and uniform deposited layers.

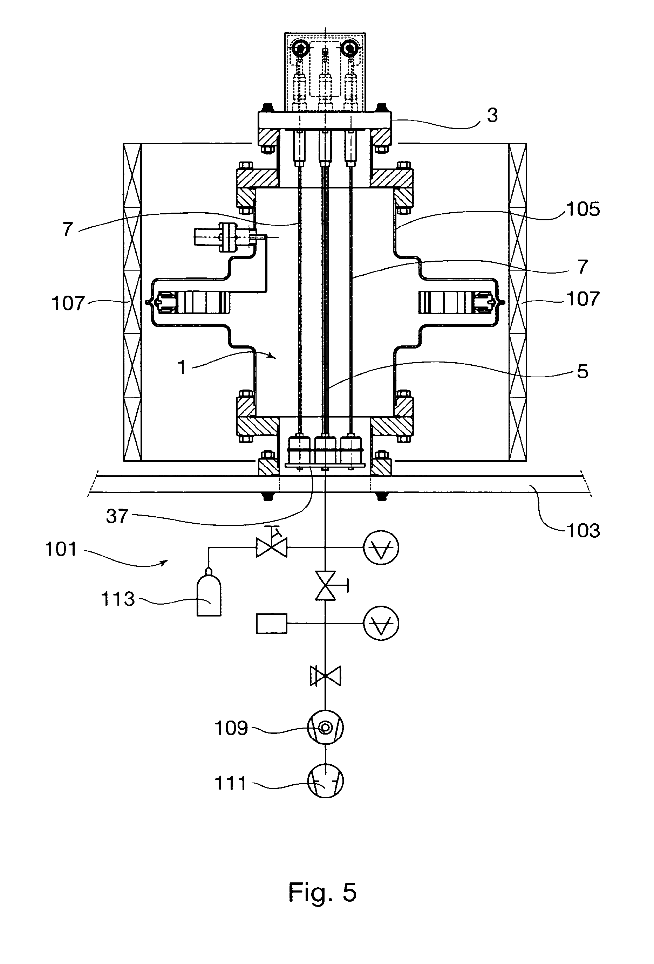

Fig. 5 schematically shows a plant 101 for the deposition of an NEG layer and a catalyst coating, which plant uses the device 1 according to the invention.

Said plant comprises a basement 103 on which there is arranged, inside a solenoid 107, chamber 105 to be coated, e.g. an ion vacuum pump.

Chamber 105 has also associated therewith, through connecting flanges, device 1 according to the invention, in such a manner that electrodes 5, 7 are inserted and suspended within chamber 105.

A turbomolecular pump 109 and a forepump 111 are connected to chamber 105 through ducts and are used to create vacuum conditions inside said chamber.

Preferably, the plant also includes a reservoir 113 for an inert gas, e.g. krypton, necessary for the deposition process by cathode sputtering.

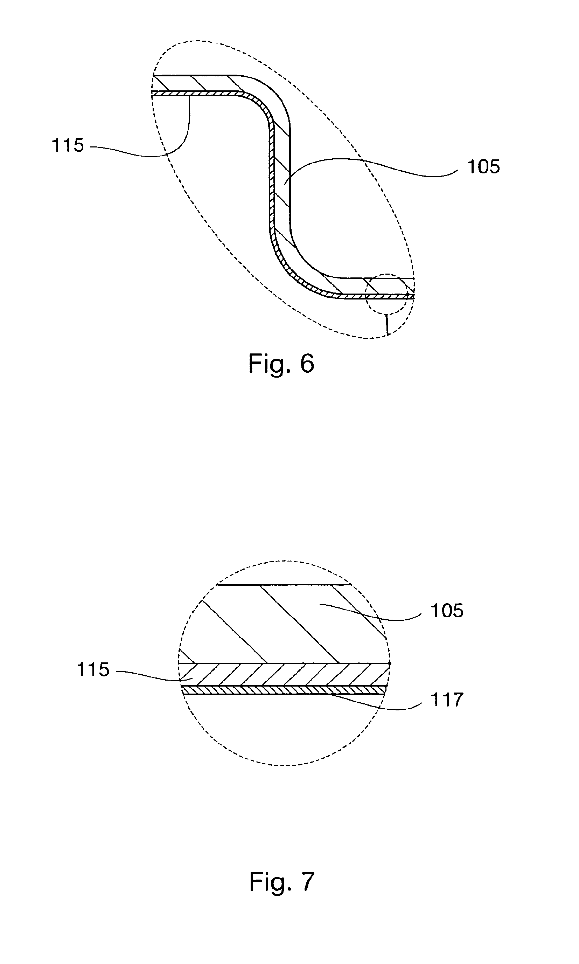

Lastly, Figs. 6 and 7 show an enlarged detail of the wall of chamber 105 during two successive steps of the coating process.

More particularly. Fig. 6 schematically shows NEG undercoat 115 at the end of the first deposition step performed by means of NEG electrode 5, and Fig. 7 shows the complete coating comprising NEG undercoat 115 and catalyst coating 117 at the end of the process.

Still referring to Fig. 7, a thin intermediate mixed layer, generally with a thickness of few nanometres, formed of NEG and catalyst and corresponding to the cleaning step of the second electrodes 7, will be present between said undercoat 115 and coating 117.

It is also clear that the above description has been given by way of non limiting example and that several changes and modifications are possible without thereby departing from the scope of the invention as defined in the appended claims.

## Claims

1. A device (1) for the deposition of non-evaporable getters (NEGs), comprising:
- a supporting plate (3);
- one or more first electrodes (5) capable of diffusing NEG material by cathode sputtering;
- one or more second electrodes (7) capable of diffusing catalyst by cathode sputtering;
wherein said first and second electrode(s) are associated with said supporting plate (3).

2. The device as claimed in claim 1, wherein said electrodes consist of rectilinear rods associated at one end with said supporting plate (3).

3. The device as claimed in claim 2, wherein the end of said electrodes remote from said supporting plate (3) is associated with a second supporting plate (37).

4. The device (1) as claimed in claim 1, wherein a single first electrode (5) is provided and is centrally associated with said supporting plate (3).

5. The device (1) as claimed in claim 4, wherein said second electrodes (7) are equally spaced along a circumference centred on said first electrode (5).

6. The device (1) as claimed in claim 4, wherein three said second electrodes are provided and are mutually spaced apart by 120° along said circumference.

7. The device (1) as claimed in claim 6, wherein said supporting plate is substantially circular, and wherein said second electrodes (7) are arranged along a circumference having a radius exceeding 50% of the radius of said supporting plate (3), and preferably ranging from 70% to 80% of the radius of said supporting plate (3).

8. The device (1) as claimed in claim 1, wherein said first electrode(s) (5) is (are) made of a material chosen out of the group comprising hafnium, scandium, titanium, vanadium, zirconium and alloys thereof.

9. The device (1) as claimed in claim 8, wherein said first electrode(s) (5) is (are) made of an alloy of titanium, vanadium and zirconium.

10. The device (1) as claimed in claim 9, wherein said first electrode(s) (5) is (are) made of an alloy containing, in weight, 26% titanium, 38% zirconium and 36% vanadium.

11. The device (1) as claimed in claim 1, wherein said second electrode(s) (7) is (are) made of a material chosen out of palladium, ruthenium, rhodium, osmium, iridium, platinum and alloys thereof.

12. The device (1) as claimed in claim 11, wherein said second electrode(s) (7) is (are) made of palladium.

13. A method for the deposition of non-evaporable getters (NEGs) by cathode sputtering, comprising the steps of:
- providing a device for the deposition of non-evaporable getters (NEGs), having a supporting plate (3), one or more first electrodes (5) capable of diffusing NEG material by cathode sputtering, and one or more second electrodes (7) capable of diffusing a catalyst by cathode sputtering, wherein said first and second electrodes are associated with said supporting plate (3);
- placing said device inside a chamber to be coated;
- evacuating the chamber to be coated, by bringing the inside space preferably to a pressure of the order of 10⁻⁷ Pa;
- introducing a noble gas, e.g. Kr, into the chamber, and bringing the chamber to a pressure in the range of about 1 to 5 Pa;
- energising the solenoid and the first electrode(s) (5), for a predetermined time, to obtain the deposition of a corresponding NEG undercoat with the desired thickness onto the chamber wall;
- stopping energising said first electrode(s) (5);
- without discontinuity in the vacuum conditions of the chamber, energising said second electrode(s) (7) made of catalyst;
- obtaining the deposition of a corresponding catalyst layer with the desired thickness onto the chamber wall, on the previously deposited NEG layer;
- stopping energising said second electrode(s) (7), turning off the solenoid and removing the device from the chamber.

14. The method as claimed in claim 13, comprising a cleaning step for removing from said one or more second electrodes (7) NEG material possibly accumulated thereon.

15. The method as claimed in claim 13 or 14, wherein said cathode sputtering steps are performed in an inert atmosphere, e.g. in a krypton atmosphere.
